# FASCICULE DE BREVET EUROPEEN

(11) **EP 1 275 009 B1**
(45) Date de publication et mention de la délivrance du brevet: **06.07.2005**
(21) Numéro de dépôt: 01928001.5
(22) Date de dépôt: 18.04.2001
(51) Int. Cl.: G01R 27/28

(54) **PROCEDE ET DISPOSITIF D'ANALYSE D'UN RESEAU DE CONDUCTEURS**
VERFAHREN UND VORRICHTUNG ZUR ANALYSE EINES NETZES
METHOD AND DEVICE FOR ANALYSING A NETWORK OF CONDUCTORS

(30) Priorité: 18.04.2000 FR 0005010
(43) Date de publication de la demande: 15.01.2003
(73) Titulaire: Kurtosis Ingenierie S.A., 92415 Courbevoie Cedex (FR)
(72) Inventeur: GARREAU, Dominique, F-95490 Vaureal (FR); FERNANDEZ, Thierry, F-92400 COURBEVOIE (FR)
(74) Mandataire: Schmit, Christian Norbert Marie
(86) Numéro de dépôt international: PCT/FR2001/001197
(87) Numéro de publication internationale: WO 2001/079870

(56) Documents cités:
- WO-A-97/27685
- US-A- 5 307 284
- US-A- 5 655 108

## Description

La présente invention a pour objet un procédé et un dispositif d'analyse d'un réseau de conducteurs. Elle est plus particulièrement utilisable dans le domaine de l'alimentation électrique de puissance, domestique ou industrielle.

Dans le domaine de l'alimentation électrique, l'intérêt de l'invention est de permettre par exemple à un fournisseur d'électricité de prévenir son client consommateur de l'historique d'utilisation d'appareils mis en service chez ce client. Un tel historique présente un intérêt immédiat. En effet, il permet de reconnaître immédiatement des pointes de consommations électriques et la nature des appareils impliqués dans cette consommation. L'utilisateur et le fournisseur d'énergie électrique peuvent alors s'accorder pour organiser un décalage dans le temps de la mise en service de certains appareils de manière à réduire la puissance crête fournie à l'utilisateur. La diminution de cette puissance crête permet alors au fournisseur d'énergie électrique, avec un même réseau de conducteurs d'alimentation électrique, de pouvoir alimenter plusieurs utilisateurs sans dépasser les tolérances en matière de dissipation thermique dans les conducteurs sollicités. Une telle surveillance conduit par ailleurs le fournisseur d'énergie électrique à consentir des tarifs avantageux aux utilisateurs qui souscrivent à une telle surveillance.

Dans le domaine de la surveillance des réseaux autres que la distribution électrique, un opérateur exploitant le réseau peut détecter des modifications des connexions du réseau et se rendre compte rapidement de l'utilisation frauduleuse ou de la mise en oeuvre d'un système d'écoute sur une liaison. D'autres besoins sont par ailleurs envisageables.

Il n'existe pas à l'heure actuelle de dispositif et de procédé d'analyse d'un réseau de conducteurs. En effet, ces réseaux peuvent être tellement complexes qu'on voit mal comment une telle analyse pourrait être menée à bien. Tout au plus on connaît dans le domaine de la détection des pannes les procédés de réflectométrie consistant, pour une liaison point à point, à émettre un signal et à mesurer une durée qui sépare l'émission de ce signal d'un écho en retour reçu au point d'émission. En divisant cette durée par la vitesse de propagation des ondes électriques dans les conducteurs, on peut en déduire le lieu où se situe la panne. Dans l'invention, le problème à résoudre est différent, il s'agit de savoir si un appareil est en service ou non. Si l'appareil est un appareil unique connecté à l'extrémité de conducteurs d'alimentations uniques, bien entendu on peut déduire du courant qui passe dans ces conducteurs l'état de marche ou d'arrêt de l'appareil connecté. Cependant, dans ce cas il ne s'agit pas d'un réseau puisqu'il n'y a qu'un seul jeu de conducteurs d'alimentation pour un seul appareil. L'invention vise quant à elle à résoudre le problème de la coexistence de multiples appareils sur un réseau de conducteurs. En pratique un réseau de conducteurs est ainsi constitué par des arborescences de connexions dont les extrémités des branches aboutissent à des appareils différenciés, en service ou non.

Ce problème sera résolu dans le procédé et le dispositif selon l'invention en mesurant à un noeud du réseau un signal électrique disponible, et notamment en en extrayant des caractéristiques spectrales et temporelles. Dans ces caractéristiques spectrales et temporelles bien entendu la fréquence du signal alternatif d'alimentation sera éliminée comme n'étant pas du tout caractéristique du phénomène d'arrêt ou de mise en service de chacun des appareils connectés à ce réseau. Dans l'invention, on s'est rendu compte que le signal disponible comportait des caractéristiques spectrales représentatives de la réflexion des ondes électriques sur les terminaisons de l'arborescence concernée.

Globalement on pourra considérer que, si un appareil n'est pas en service, l'extrémité du conducteur d'alimentation qui y aboutit peut être considérée comme étant en l'air. Elle se comporte alors comme un circuit ouvert et provoque des réflexions des signaux propagés dans les conducteurs. A l'opposé, si l'appareil est en service, on pourra considérer que l'extrémité de connexion est connectée à une charge; l'écho est donc différent.

Compte tenu d'une architecture donnée du réseau de conducteurs, on considère dans l'invention que cette architecture n'a pas à être modifiée trop fréquemment. En effet, les mises en service de nouveaux ateliers, de nouveaux bureaux par interconnexions de réseaux électriques ne sont pas aussi fréquentes que les mises en service ou les arrêts quotidiens des appareils connectés à ces réseaux. On peut ainsi estimer que le caractère stable de l'architecture de conducteurs sous surveillance peut durer de l'ordre d'un mois. Au besoin, dans l'invention on mesurera une modification des caractéristiques du réseau correspondant à une évolution de son architecture.

Dans l'invention, on a pu montrer, en se livrant à des analyses assez fines des caractéristiques spectrales et/ou temporelles, qu'il était possible d'identifier l'état de marche ou d'arrêt des divers appareils connectés à un réseau. Au besoin on peut se limiter à l'étude de certains des appareils connectés seulement. On pourra choisir ainsi de surveiller certains appareils identifiables par avance, à l'exclusion d'autres appareils dont on ne se préoccupe pas.

Le document WO-9727685 décrit un dispositif et un procédé d'analyse d'un réseau dans lequel on mesure un signal disponible à un noeud du réseau et on produit une image de ce signal. On compare ensuite l'image produite à une image attendue et on identifie l'émetteur du signal qui est relié parmi plusieurs autres émetteurs réseau et qui correspond à cette image attendue.

La présente invention à donc pour objet un procédé d'analyse d'un réseau de conducteurs d'alimentation électrique caractérisé en ce qu'il comporte des étapes dans lesquelles
- on mesure à un noeud du réseau un signal disponible,
- on produit une image temporelle et ou spectrale du signal disponible,
- on compare l'image produite à une image attendue,
- on en déduit un état de fonctionnement allumé ou éteint, d'un appareil relié au réseau correspondant à cette image attendue.

L'invention à également pour objet un dispositif d'analyse d'un réseau de conducteurs d'alimentation électrique comportant un circuit de mesure à un noeud du réseau d'un signal disponible, un circuit pour produire une image temporelle et ou spectrale du signal disponible, caractérisé en ce qu'il comporte un circuit pour comparer l'image produite à une image attendue, et un circuit pour déduire un état de fonctionnement d'un appareil correspondant à cette image attendue.

L'invention sera mieux comprise à la lecture de la description qui suit et à l'examen des figures qui l'accompagneront. Celles-ci ne sont présentées qu'à titre indicatif et nullement limitatif de l'invention. Les figures montrent :
- Figure 1 : selon l'invention la représentation schématique d'un réseau de conducteurs et, dans un cas particulier, l'injection, d'un signal caractéristique et la mesure du signal caractéristique réfléchi par le réseau à titre de signal disponible ;
- Figure 2 : la représentation schématique du dispositif de production d'une image du signal disponible mesuré ;
- Figures 3a et 3b : les représentations temporelles de signaux mesurés pour un appareil montrant une différence de réponse selon que l'appareil est en arrêt ou en marche.

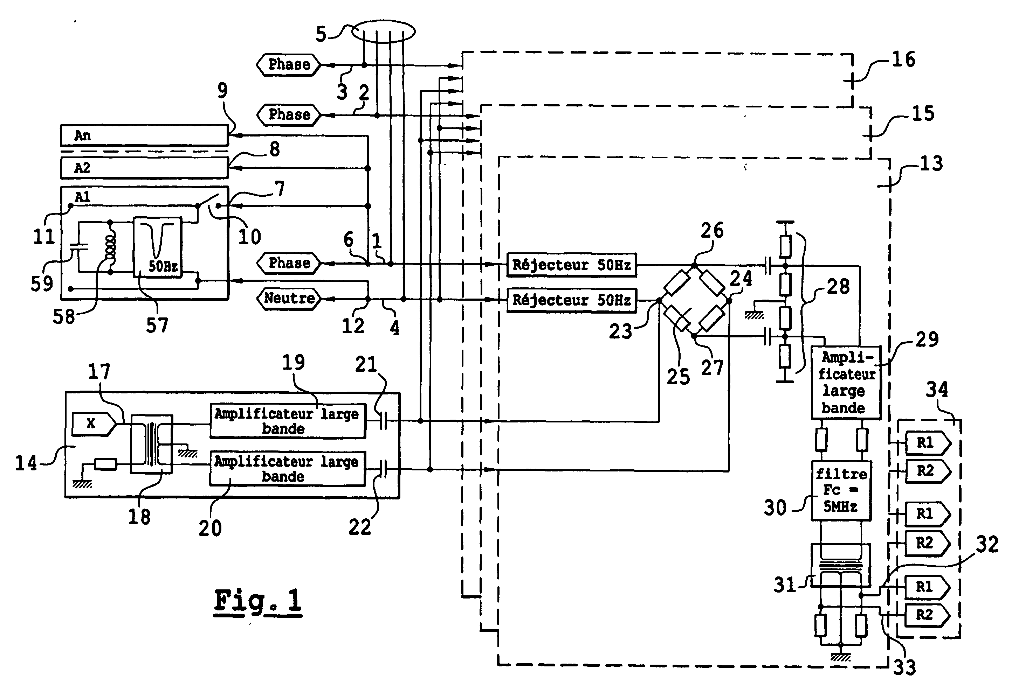

La figure 1 montre un dispositif utilisable pour mettre en oeuvre le procédé d'analyse d'un réseau de conducteurs selon l'invention. Un réseau de conducteurs peut, dans un exemple, être un réseau 5 de conducteurs d'alimentation électrique. Il comporte, dans un cas général, trois conducteurs de phases 1, 2 et 3 et un conducteur neutre 4. Bien qu'un tel réseau 5 soit ici un réseau triphasé, l'explication qui suivra se rapportera à un réseau d'alimentation électrique monophasé ou seul une phase, celles des deux conducteurs 1 et 4 est impliqué.

La particularité du réseau 5 est qu'il permet de connecter et de mettre en service un certain nombre d'appareils, ici par exemple les appareils A1, A2,...An. A partir d'un noeud 6 de ce réseau, le réseau 5 présente donc une arborescence avec des extrémités de connexion 7, 8 et 9 pour alimenter les appareils A1,...An. Chaque appareil est muni, d'une manière ou d'une autre, d'un interrupteur tel que 10 permettant de relier une des extrémités 7 à 9 à une entrée de service 11 de l'appareil ou au contraire de laisser l'extrémité 7 en l'air. Selon le cas, on considérera que l'impédance présentée par l'appareil connecté, vu du réseau, est une impédance adaptée, ou désadaptée respectivement. Bien entendu, tous les appareils A1 à An sont destinés à être mis en service aléatoirement et le but de l'invention est de produire une information relative à la mise en service de chacun de ces appareils.

Dans ce but, dans l'invention on mesure à un noeud du réseau, en particulier au noeud 6, un signal disponible. Compte tenu du caractère électrique, la mesure au noeud 6 se fera par rapport à un autre noeud, par exempte au noeud 12 situé sur la connexion de neutre 4. La notion de noeud recouvre une signification générique. Elle signifie un endroit où est prélevé un signal disponible.

Le signal disponible peut être un signal de bruit existant dans le réseau. 5. En effet, les appareils électriques lorsqu'ils sont connectés ont plusieurs effets sur le bruit. D'une part, ils modifient l'impédance du réseau, ce qui influe sur le bruit disponible au noeud 6. D'autre part, de nombreux appareils génèrent eux-mêmes un bruit propre caractéristique de leur mise en service. A titre de perfectionnement, plutôt que de mesurer le bruit comme signal disponible, dans l'invention on préfèrera injecter dans les noeuds 6 et 12 un signal caractéristique pour récupérer à l'endroit de cette injection ce signal caractéristique réfléchi par le réseau 5.

Un dispositif d'injection utilisé dans ce but comporte un coupleur 13 relié à un injecteur 14. Dans le cas où on a affaire à un réseau triphasé, le coupleur 13 est dupliqué en coupleurs 15 et 16 identiques. L'injecteur 14 comporte dans un exemple une entrée 17 de signal à injecter reliée à la masse par un primaire d'un transformateur électrique 18. Le signal prélevé au secondaire du transformateur 18 est appliqué, notamment par l'intermédiaire d'amplificateurs large bande 19 et 20 et de condensateurs 21 et 22 respectivement en série, à deux entrées 23 et 24 d'un pont de Wheastone 25. Deux sorties intermédiaires 26 et 27 du pont 25 sont reliées, notamment par l'intermédiaire d'un circuit de polarisation 28, d'un amplificateur large bande 29, d'un filtre passe-bas 30 et d'un transformateur 31 (du même type que le transformateur 18) à deux sorties de mesures 32 et 33 pour produire des signaux R1 et R2.

L'injection dans le réseau 5 se réalise en connectant une des entrées, par exemple l'entrée 23 du pont 25 et un point milieu d'une des branches de ce pont, par exemple le point milieu 26, au réseau 5, ici respectivement au conducteur 4 et 1. De préférence la connexion au réseau 5 est réalisée par l'intermédiaire de deux filtres réjecteurs permettant d'éliminer dans le signal reçu une composante de fluctuation alternative du réseau d'alimentation. Ici la fréquence de réjection de 50 Hz devra être modifiée si le réseau d'alimentation électrique est à une autre fréquence, notamment 60 Hz. Dans le cas où la surveillance d'un réseau d'alimentation électrique continu est envisagé, notamment dans le cas de la surveillance de publiphones, les réjecteurs seront remplacés par des filtres passe-haut. Le coupleur 13 joue un rôle d'un duplexeur.

Le fonctionnement de ce duplexeur est le suivant. Un signal électrique produit par l'injecteur 14, et admis sur les entrées 23 et 24 du pont 25, retentit, si les résistances du pont 25 sont très exactement calculées, en un signal nul disponible entre les bornes de sorties 26 et 27. Par contre ce signal injecté retentit en un signal significatif disponible entre les bornes 23 et 26. Ce signal émis est donc transmis au travers des filtres réjecteurs sur les conducteurs 1 et 4 d'où il se propage jusque dans les appareils A1 à An.

En fonction de l'état de marche ou d'arrêt de ces appareils, ce signal est réfléchi et revient dans les filtres réjecteurs aux points 23 et 26 du pont 25. De là, une partie de la puissance entre dans le circuit de polarisation 28 par l'intermédiaire des points 26 et 27, une autre partie est dirigée vers l'injecteur 14 par l'intermédiaire des points 23 et 24. Le transformateur 18, ainsi que les composants auxquels il est connecté, sont réglés de telle façon que l'écho reçu et renvoyé dans l'injecteur 18 soit le plus parfaitement possible dissipé dans cet injecteur, sans réflexion parasite. On montrera par ailleurs par la suite comment s'affranchir de fuites du duplexeur.

En ce qui concerne les coupleurs 15 et 16, ils sont identiques aux coupleurs 13 en ce sens qu'ils reçoivent des signaux de l'unique (de préférence) injecteur 14. Ils sont différents en ce sens qu'ils sont reliés au neutre 4 mais à un autre conducteur 2 ou 3 du réseau triphasé 5. Ces autres coupleurs produisent eux aussi en sortie de leur transformateur 31 des signaux R1 et R2 disponibles sur les deux pôles du secondaire de ces transformateurs.

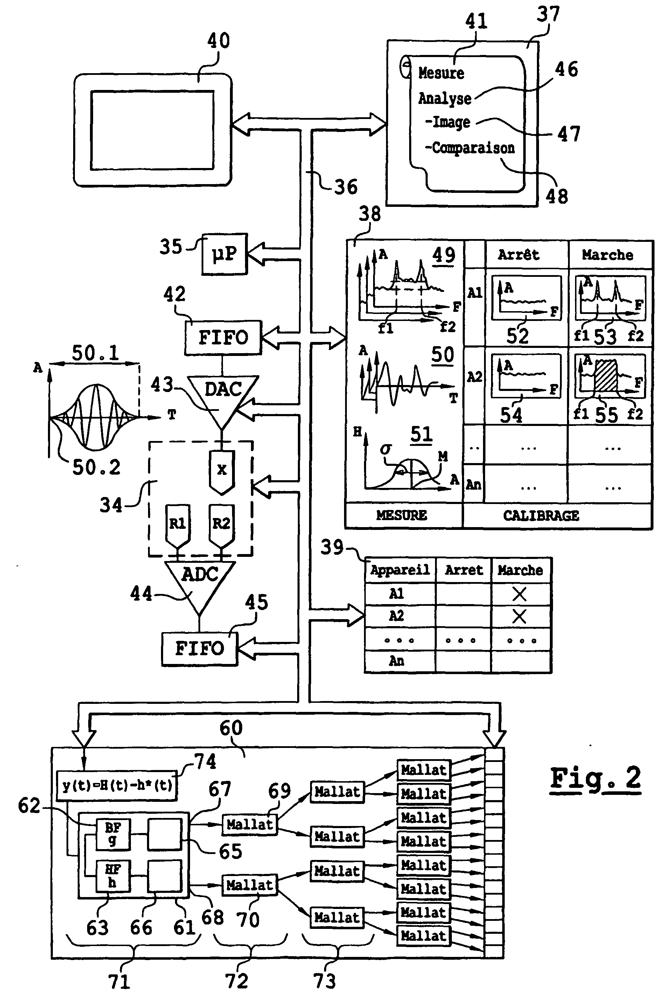

La figure 2 montre de manière plus précise le dispositif d'analyse et le procédé mis en oeuvre. Les signaux X injectés et R1 et R2 mesurés sont disponibles à une interface d'injection 34. D'une manière préférée, le dispositif de mesure de l'invention sera un dispositif programmable. A cet effet il comporte un microprocesseur 35 relié par l'intermédiaire d'un bus 36 de données, d'adresses et de commandes à une mémoire programme 37, une mémoire de données 38, une mémoire de résultats 39 ainsi qu'à un écran de visualisation 40.

Pour la mise en oeuvre d'un programme 41 de mesure, le microprocesseur 35 charge dans une mémoire 42, du type premier entré premier sortie, des échantillons d'un signal numérique caractéristique à injecter. Ces échantillons numériques sont convertis par un convertisseur numérique analogique 43 en un signal X, analogique, disponible sur l'interface 34 reliée par ailleurs au dispositif d'injection de la figure 1. En réception, les signaux R1 et R2 mesurés sont convertis par un convertisseur analogique numérique 44 et chargés au fur et à mesure de leur arrivée dans une mémoire du type premier entré premier sorti 45. Les circuits 42, 43, 44 et 45 ainsi que l'interface 34 sont bien entendu administrés par le microprocesseur 35.

Une fois que la mesure du signal d'écho est réalisée, un programme d'analyse 46 contenu dans la mémoire 37 lance un premier sous-programme 47 de production d'image et un deuxième sous-programme 48 de comparaison de l'image produite à une image attendue. L'image produite peut être une image spectrale 49 ou une image temporelle 50. A partir de l'historique temporel 50 du signal disponible, on peut extraire un certain nombre d'échantillons numériques, par exemple dans un mode préféré 1024 échantillons numériques. L'image temporelle peut par ailleurs être une image statistique 51.

Pour l'obtention de cette dernière, on provoquera une mesure synchrone de plusieurs expérimentations. Ainsi, dans un exemple, le signal émis par le convertisseur 43 sera un signal fenêtré temporellement pendant une fenêtre 50.1, à partir d'une date de départ 50.2. Le signal reçu converti par le convertisseur 44 peut être indexé à compter de la date 50.2. Sur le plan pratique, compte tenu que les réseaux étudiés sont des réseaux à courte distance, et avec une fréquence de conversion dans les convertisseurs 43 et 44 de 1 MHz, on pourra prévoir sur la période 50.1 d'identifier les échantillons reçus par leur date de mesure, par un numéro d'échantillon, par rapport à la date 50.2. Si on réitère l'expérimentation à l'identique, on peut acquérir ainsi plusieurs jeux d'échantillons stockables dans la mémoire 45. On effectue alors un traitement statistique, ici par simple moyennage des échantillons possédant un même index, pour éliminer les conséquences d'un bruit étranger au signal émis pendant la fenêtre 50.1. Cette technique porte le nom de moyennage synchrone. On dispose ainsi pour chaque indice temporel d'une valeur moyenne et d'une variance du signal d'écho calculé sur les différentes expérimentations réalisées (typiquement 100).

Dans un exemple la fenêtre 50.1 est dite sinusoïdale car, pendant sa durée, l'amplitude du signal injecté possède une enveloppe sinusoïdale.

Qu'on travaille sur un signal réfléchi ou sur le bruit du réseau, il est par ailleurs prévu dans l'invention de se livrer à une analyse spectrale du signal disponible. Cette analyse spectrale vient en complément de l'analyse temporelle. Dans cette analyse spectrale, on effectue une décomposition spectrale des signaux disponibles pour chaque expérimentation. Les amplitudes des composantes spectrales sont alors indexées par des valeurs de fréquences. Pour plusieurs expérimentations successives, comme dans le cas temporel, il est possible, pour chaque valeur de fréquences d'extraire une composante moyenne de spectre ainsi qu'une variance d'une composante spectrale. De préférence l'analyse spectrale sera-t-elle aussi menée sur 1024 composantes spectrales avec une quantification, après traitement statistique sur deux octets pour chacune des composantes.

En définitive l'image produite correspondant au signal disponible sera une image comportant, dans un mode préféré, 1024 valeurs de spectre moyen, 1024 valeurs de variance spectrale, 1024 amplitudes moyennes d'écho, et 1024 variances d'écho. Chaque valeur étant codée sur deux octets, l'image produite occupera en mémoire une place correspondant à huit K octet.

Pour reconnaître ensuite un état de marche ou d'arrêt d'un appareil il faut comparer l'image du signal disponible à une image attendue. Dans la mémoire de données 38 sont donc présentes, en complément de l'image produite du signal disponible, des images relatives à chacun des appareils, et correspondant à leur état de marche et d'arrêt. Pour chaque appareil une image attendue de marche au moins, et une image attendue d'arrêt général comporteront une même structure que l'image produite du signal disponible. En pratique, la mémoire 38 comportera une mémorisation 52 de l'image attendue pour tous les appareils à l'arrêt, et une image 53 pour l'appareil A1 en fonctionnement. De même pour l'appareil A2 on disposera des images 54 et 55, et ainsi de suite pour les autres appareils. On notera que l'image 52 est identique à l'image 54. Elle n'a pas besoin d'être stockée plusieurs fois.

On a ici schématiquement représenté sur les images 52 à 55 uniquement des composantes spectrales. Ainsi pour l'appareil A1 selon qu'il est à l'arrêt ou en marche, des composantes spectrales de fréquences f1 et f2 ne sont pas ou sont au contraires présente. Pour l'appareil A2 des composantes spectrales situées entre les fréquences f1 et f2 sont absentes ou présentes respectivement. Schématiquement, dans le signal mesuré 49 on détecte la présence significative des composantes spectrales f1 et f2, de même qu'une présence significative de composantes situées entre f1 et f2. On en déduira, pour le signal mesuré 49 qu'il correspond à un état de marche des appareils A1 et A2 seulement. En réalité, la comparaison sera réalisée entre une image produite avec ses échantillons temporels et spectraux, moyens et de variance, et les images correspondantes globales 52, 53, et 54.

Rendu à ce stade, il reste à expliquer comment sont obtenu les images 52 à 55 et par ailleurs comment sont obtenues les déductions indiquées ci-dessus, permettant d'afficher dans la mémoire de résultat 39 que les appareils A1 et A2 sont en marche ou non au moment de la mesure.

L'obtention des images 52 à 55 peut être réalisée de plusieurs façon. D'une manière préférée, sur une installation inconnue, on procèdera à un calibrage. Dans ce cas, le fournisseur d'électricité et l'utilisateur coopèrent pour arrêter tous les appareils et mesurer un signal disponible 52 (ou 54 qui est le même) représentatif de l'architecture du réseau quand aucun appareil n'est en état de marche. Puis chaque appareil est mis en service seul et pendant cette mise en service une image 53 ou 55 ou autre est mesurée comme pour les images 49 et 51. Elle est associée dans la mémoire 38 à l'appareil concerné. Dans l'exemple chiffré ci-dessus, une image attendue occupant 8K octets, la mémoire devra avoir une capacité telle qu'elle puisse contenir autant de fois 8 K octets qu'il y a d'appareils à surveiller plus un.

D'une autre façon, on peut prévoir de munir chaque appareil d'un circuit d'identification 56. Un tel circuit 56 est montré sur la figure 1. Ce circuit 56 comporte deux entrées, raccordées sur les conducteurs d'alimentation, 1 et 4 mais après l'interrupteur de mise en service 10. Autrement dit, lorsque l'appareil A1 montré n'est pas en état de marche, le circuit 56 n'est pas vu par le coupleur 13 de l'appareil de mesure. Lorsque par contre l'appareil A1 est en marche le circuit 56 est vu et réinjecte sur le réseau le signal qui le caractérise. Le circuit 56 selon l'invention comportera de préférence un réjecteur de fréquence d'alimentation 57 connecté par ailleurs en parallèle d'un montage bouchon comportant une inductance 58 en parallèle avec un condensateur 59. Le montage 58-59 est prévu pour résonner à une fréquence caractéristique dépendante de la valeur de l'inductance 58 et de celle du condensateur 59. En choisissant des composants 58 et 59 identiques, mais de mauvaise qualité de fabrication, on est certain que chaque circuit aura, avec la précision de mesure indiquée dans l'invention, un comportement suffisamment différent pour caractériser l'appareil. Dans ce cas, l'image statistique spécifique d'un appareil représentera les composantes spectrales spécifiques du circuit 58, 59. Dans ce cas l'opération de calibrage de chaque appareil en état de marche n'est pas nécessaire, il suffit de faire un calibrage du réseau lorsque aucun n'appareil n'est en service, ce qui est relativement facile à faire.

La décomposition spectrale pourra être réalisée par des circuits FFT, (Fast Fourier Transform - circuits à transformée de Fourier rapide). Mais de préférence, elle sera réalisée par une décomposition du signal reçu en ondelettes. Pour produire un signal correspondant à cette décomposition en ondelettes, de préférence, on utilisera des signaux caractéristiques connus en émission pour accepter une telle décomposition. La figure 2 montre, d'une manière simplifiée, un filtre 60 utile pour décomposer un signal reçu en ondelettes. Pour réaliser le filtre 60, on retiendra une décomposition hiérarchique des signaux reçus et numérisés dans laquelle on décompose itérativement un signal de M échantillons en L signaux de M/L échantillons. D'une manière préférée la décomposition sera dyadique (alors qu'elle pourrait être triadique ou autre) et dans ce cas L vaudra 2. La figure 1 montre une décomposition dyadique. Une telle décomposition est notamment décrite dans l'article "A theory for multiresolution signal décomposition : the wavelet representation", revue IEEE Transaction on pattern analysis and machine intelligence, Vol. 11, pages 674-693, juillet 1989, dû à Stéphane MALLAT.

Dans une étape d'une telle décomposition, dans un circuit de traitement 61 on décompose le signal numérique reçu en une composante basse fréquence et une composante haute fréquence. En pratique le traitement est logiciel, mais l'explication sous forme de circuits ou de fonctions est plus propice à la compréhension. Le circuit 61 est un circuit de type Mallat. Sa fonction est équivalente à faire passer le signal d'une part dans un filtre 62 à réponse impulsionnelle finie basse fréquence, de fonction de transfert g, et d'autre part dans un filtre 63 à réponse impulsionnelle finie haute fréquence, de fonction de transfert h. Pour simplifier les idées, la fréquence de coupure commune aux filtres 62 et 63 du circuit 61 sera une fréquence située au milieu de la bande passante du signal R1 - R2. Dans un exemple préféré les filtres 62 et 63 sont des filtres numériques avec Q coefficients, c'est-à-dire capable d'une mémorisation de Q échantillons (à une première itération). Le nombre Q de coefficients est pris de préférence égal à 10, c'est suffisant.

Selon la théorie présentée dans l'article ci-dessus, la quantité d'information du signal admis à l'entrée des filtres 62 et 63 n'est pas dégradée si on échantillonne le signal produit par chacun de ces filtres 62 et 63 avec un rythme moitié moins important que celui du signal admis en entrée du circuit Mallat 61. Dans ce but, on sous-échantillonne par des circuits de sous-échantillonnage respectivement 65 et 66 les signaux délivrés par les filtres 62 et 63. Alternativement, on peut ne faire travailler les filtres 62 et 63, numériques, qu'une fois sur deux, c'est-à-dire au niveau élémentaire une fois qu'ils ont reçu deux échantillons successifs. Sur le plan pratique, ici on a montré que les échantillons étaient tous traités mais qu'on n'en retenait que un sur deux.

Si la décomposition est triadique, au lieu d'avoir un filtre basse fréquence 62 et un filtre haute fréquence 63, on aura ces deux filtres situés de part et d'autre d'un filtre intermédiaire. Dans ce cas la fréquence de coupure des filtres sera remplacée par deux fréquences de coupure tendant à diviser la bande globale en trois parties égales. Ainsi de suite on peut généraliser l'explication.

Le circuit 61 délivre ainsi des composantes basse fréquence sur une sortie 67 et des composantes haute fréquence sur une sortie 68. Ces composantes basse fréquence et haute fréquence subissent chacune dans des circuits 69 et 70, eux aussi du type Mallat, mais pour une itération ultérieure, des transformations dans des circuits identifiés Mallat mettant en oeuvre une décomposition identique à la décomposition du circuit 61.

Néanmoins d'une itération 71, décrite, à une itération 72 suivante, les fréquences de coupure des circuits Mallat 69 et 70, respectivement basse fréquence et haute fréquence, seront des fréquences situées à chaque fois à la moitié des demi-bandes globales séparées par la fréquence de coupure. Ainsi de suite les itérations ultérieures, par exemple l'itération 73, permettent d'effectuer un traitement identique. On a montré ici quatre itérations conduisant en sortie à disposer de huit circuits Mallat, donc de seize ondelettes. S'agissant d'une décomposition en 2⁸, le nombre d'itérations sera égal à 8. L'exemple est seulement montré ici d'une manière simplifiée avec quatre itérations. Avec 8 itérations on disposera de 1024 échantillons de sortie. Chacun de ces échantillons peut alors être traité séparément.

Pour éditer le signal caractéristique émis, on pourra utiliser des circuits Mallat inversés, munis chacun d'une voie basse fréquence et d'une voie haute fréquence. Chaque voie comportera alors un circuit de suréchantillonnage. Dans un cas particulier préféré, le circuit de suréchantillonnage ajoutera un zéro entre chaque échantillon provenant d'un circuit Mallat inverse antérieur. Chaque circuit de suréchantillonnage sera suivi d'un filtre, respectivement basse fréquence ou haute fréquence conjugué des filtres 62 et 63. Les sorties des deux filtres conjugués seront reliés à un additionneur logique. Cet additionneur logique pourra éventuellement être tabulé. Il additionnera sur R+1 bits les signaux quantifiés sur R bits provenant des sorties des filtres conjugués pour reconstituer une suite de M échantillons. En agissant ainsi, à partir de 1024 ondelettes on peut numériquement constituer le signal X. En réception, le circuit 60 servira à effectuer la décomposition inverse.

La décomposition en ondelettes de Mallat étant inversible, le signal d'origine peut donc être reconstruit. En pratique, il est possible de déterminer l'état du réseau directement à partir de la connaissance du signal dans les sous-bandes, cette reconstruction n'est donc pas nécessaire.

La méthode peut être mise en oeuvre en envoyant une impulsion de dirac et en décomposant l'écho reçu à l'aide de l'algorithme de Mallat. De façon préférée dans l'invention, on émettra directement les ondelettes correspondant aux différentes sous-bandes. Les échos correspondant fournissant directement la décomposition en sous-bande de l'écho correspondant à une impulsion de Dirac.

De préférence en réception, le circuit 60 comportera un circuit d'élimination 74. Dans le circuit 74, on soustraira de chaque échantillon reçu la contribution apportée par les fuites du duplexeur 25. Ces fuites ne représentent pas l'écho. Pour la mesure de ces fuites, on charge les conducteurs 1 et 4 par une charge parfaitement adaptée, et on mesure le signal prétendument reçu. Ce dernier n'est représentatif que des fuites. Pour le soustraire, on en extrait une version indexée par échantillons. Cette mesure peut par ailleurs être faite en laboratoire.

En pratique les traitements numériques ci-dessus sont mis en oeuvre par le microprocesseur 35. On notera que le filtre 61 doit produire deux fois M/2 échantillons alors que les filtres 69 et 70 doivent produire, ensemble, quatre fois M/4 échantillons. En définitive le travail effectué par le microprocesseur, pour chaque étape ou chaque itération, est identique. Dans un circuit 60, avec des filtres tels que 62 et 63 à M coefficients ceci revient à effectuer 2 x M x 8 opérations élémentaires à chaque fois. Un tel traitement est tout à fait à la portée d'un microprocesseur de traitement numérique à bas coût.

Pour effectuer maintenant la comparaison de l'image produite à une image attendue, il faut minimiser une distance existant entre chacune des quatre K valeurs d'une image 49-51 produite et une composition algébrique des images 52-55 attendues. Cette composition correspond aux états de marche des différents appareils. Cette minimisation peut être réalisée de différentes façons connues. Elle peut être menée soit par une méthode de type régression aux moindres carrés, soit en utilisant un réseau de neurones. Une méthode, utilisant un tel réseau de neurone, connue en soi est préférée car elle est plus rapide et moins exigeante en termes de ressources électroniques de traitement.

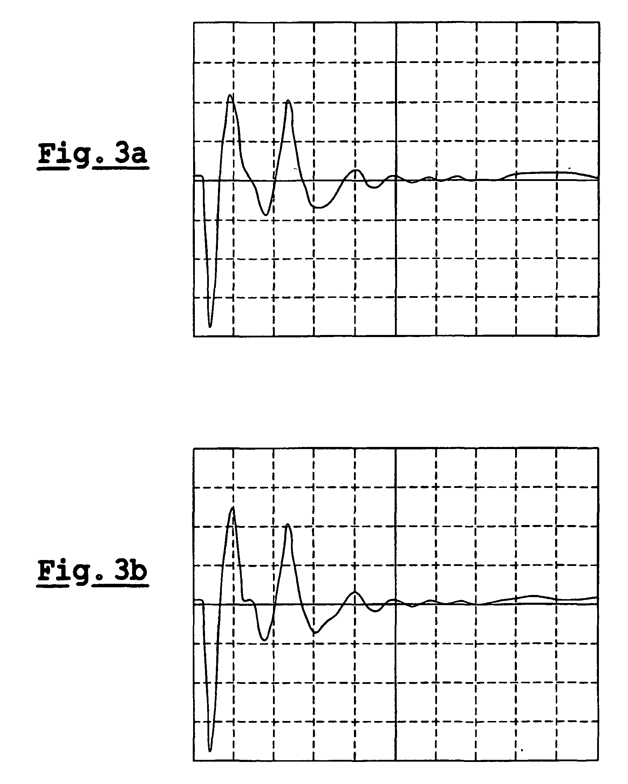

Les figures 3a et 3b montrent à titre d'exemple une mesure réelle d'un signal temporel d'écho disponible selon que l'appareil étudié est à l'arrêt ou en marche.

## Revendications

1. Procédé d'analyse d'un réseau (5) de conducteurs (1-4) d'alimentation électrique **caractérisé en ce qu'**il comporte des étapes dans lesquelles :
- on mesure (41) à un noeud (6) du réseau un signal disponible,
- on produit (47) une image temporelle (50) et ou spectrale (49) du signal disponible,
- on compare (48) l'image produite à une image attendue,
- on en déduit un état (39) de fonctionnement allumé ou éteint, d'un appareil parmi plusieurs reliés au réseau et correspondant à cette image attendue.

2. Procédé selon la revendication 1, **caractérisé en ce que** :
- on mesure le signal disponible à plusieurs reprise,
- on compose une image statistique (51) du signal mesuré, et
- on compare l'image statistique à l'image attendue.

3. Procédé selon l'une des revendications 1 à 2, **caractérisé en ce que** :
- on émet un signal (X) caractéristique (42, 43, 52, 53) depuis un noeud du réseau, et
- on mesure à titre de signal disponible un écho (R1, R2) réfléchi par le réseau de conducteurs, de ce signal émis.

4. Procédé selon la revendication 3, **caractérisé en ce que** pour mesurer :
- on décompose le signal en ondelettes de bandes de fréquence séparées, et
- on traite les signaux d'ondelettes séparément.

5. Procédé selon l'une des revendications 1 à 4, **caractérisé en ce que** :
- on produit les images attendues des appareils par un calibrage du réseau de conducteurs au cours duquel
- on mesure au noeud du réseau le signal disponible pour un état de marche et pour un état d'arrêt d'appareil.

6. Procédé selon l'une des revendications 1 à 5, **caractérisé en ce que** :
- pour comparer, on met en oeuvre un procédé d'analyse par réseau de neurones.

7. Dispositif d'analyse d'un réseau de conducteurs d'alimentation électrique comportant un circuit (35-48) de mesure à un noeud du réseau d'un signal disponible, un circuit pour produire une image temporelle (50) et ou spectrale (49) du signal disponible, **caractérisé en ce qu'**il comporte un circuit (35, 37, 38) pour comparer l'image produite à une image attendue, et un circuit pour déduire un état de fonctionnement d'un appareil parmi plusieurs reliés au réseau et correspondant à cette image attendue.

8. Dispositif selon la revendication 7, **caractérisé en ce qu'**il comporte un duplexeur (25) pour émettre un signal caractéristique depuis un noeud du réseau, et pour recevoir à titre de signal disponible un écho réfléchi par le réseau de conducteurs de ce signal émis.

9. Dispositif selon la revendication 8, **caractérisé en ce qu'**il comporte un circuit (74) d'élimination, dans le signal disponible, d'une fuite du signal émis.

10. Dispositif selon l'une des revendications 7 à 9, **caractérisé en ce qu'**il comporte un bouchon réactif d'identification monté en parallèle sur l'entrée d'alimentation d'un appareil.

## Patentansprüche

1. Verfahren zur Analyse eines Netzes (5) von Leitern (1-4) zur Stromversorgung, **dadurch gekennzeichnet, dass** es Schritte enthält, in welchen:
- man an einem Knoten (6) des Netzes ein verfügbares Signal misst (41),
- man ein vorübergehendes Bild (50) oder spektrales Bild (49) des verfügbaren Signals erzeugt (47),
- man das erzeugte Bild mit einem erwarteten Bild vergleicht (48),
- man davon einen eingeschalteten oder ausgeschalteten Betriebszustand (39) eines Geräts von mehreren ableitet, die an das Netz angeschlossen sind und diesem erwarteten Bild entsprechen.

2. Verfahren nach Anspruch 1, **dadurch gekennzeichnet, dass** man:
- das verfügbare Signal mehrmals misst,
- man ein statistisches Bild (51) des gemessenen Signals zusammenstellt und
- man das statistische Bild mit dem erwarteten Bild vergleicht.

3. Verfahren nach einem der Ansprüche 1 bis 2, **dadurch gekennzeichnet, dass**:
- man ein charakteristisches Signal (X) (42, 43, 52, 53) ausgehend von einem Knoten des Netzes sendet und
- man als verfügbares Signal ein Echo (R1, R2) dieses gesendeten Signals, das von dem Netz von Leitern reflektiert wird, misst.

4. Verfahren nach Anspruch 3, **dadurch gekennzeichnet, dass** man zum Messen:
- das Signal in Wellen mit getrennten Frequenzbändern zerlegt und
- man die Wellensignale getrennt verarbeitet.

5. Verfahren nach einem der Ansprüche 1 bis 4, **dadurch gekennzeichnet, dass**:
- man die erwarteten Bilder der Geräte durch ein Kalibrieren des Netzes von Leitern erzeugt, während dessen
- man an dem Knoten des Netzes das verfügbare Signal für einen Betriebszustand und für einen Stoppzustand eines Geräts misst.

6. Verfahren nach einem der Ansprüche 1 bis 5, **dadurch gekennzeichnet, dass**
- man zum Vergleichen ein Analyseverfahren durch Neuronennetz anwendet.

7. Analysegerät eines Netzes von Stromversorgungsleitern, das einen Schaltkreis (35-48) zum Messen an einem Knoten des Netzes eines verfügbaren Signals, einen Schaltkreis zum Erzeugen eines vorübergehenden Bilds (50) oder spektralen Bilds (49) des verfügbaren Signals umfasst, **dadurch gekennzeichnet, dass** es einen Schaltkreis (35, 37, 38) umfasst, um das erzeugte Bild mit einem erwarteten Bild zu vergleichen, und einen Schaltkreis, um einen Betriebszustand eines Geräts von mehreren, die an das Netz angeschlossen sind, und diesem erwarteten Bild entsprechen, abzuleiten.

8. Gerat nach Anspruch 7, **dadurch gekennzeichnet, dass** es einen Duplexer (25) umfasst, um ein charakteristisches Signal von einem Knoten des Netzes ausgehend zu senden, und um als verfügbares Signal ein Echo, das von dem Netz von Leitern dieses gesendeten Signals reflektiert wird, zu empfangen.

9. Gerät nach Anspruch 8, **dadurch gekennzeichnet, dass** es einen Schaltkreis zum Eliminieren (74) eines Lecks des gesendeten Signals aus dem verfügbaren Signal umfasst.

10. Gerät nach einem der Ansprüche 7 bis 9, **dadurch gekennzeichnet, dass** es einen reaktiven Identifikationsstopfen umfasst, der parallel auf dem Versorgungseingang eines Geräts installiert ist.

## Claims

1. A method for analyzing a network (5) of electrical supply conductors (1-4) **characterized in that** the method comprises steps in which:
- an available signal is measured (41) at a network node (6),
- a temporal (50) and/or spectral (49) image of the available signal is produced (47),
- the image produced (48) is compared to an expected image,
- an on or off operational state is deduced (39) of an apparatus corresponding to this expected image from among several connected to the network.

2. The method according to claim 1, **characterized in that**:
- the available signal is measured repeatedly,
- a statistical image (51) of the measured signal is composed, and
- the statistical image (51) is compared to the expected image.

3. The method according to one of claims 1 to 2, **characterized in that**:
- a characteristic (42, 43, 52, 53) signal (X) is emitted from a network node,and
- an echo (R1, R2) reflected by the conductor network is measured as an available signal of this emitted signal.

4. The method according to claim 3, **characterized in that**, to measure:
- the signal is broken down into separate frequency band wavelets, and
- the wavelet signals are processed separately.

5. The method according to one of claims 1 to 4, **characterized in that**:
- the images expected from the apparatuses are produced by calibrating the conductor network during which
- the available signal is measured at the network node for an on state and an off state of the apparatus.

6. The method according to one of claims 1 to 5, **characterized in that**:
- an analysis method is established by the neuron network for comparison.

7. A device for analyzing an electrical supply conductor network comprising a circuit (35-48) for measuring an available signal at a network node, a circuit for producing a temporal (50) and/or a spectral (49) image from the available signal, **characterized in that** the device comprises a circuit (35, 37, 38) for comparing the produced image to an expected image, and a circuit for deducing an operational state of an apparatus from among several connected to the network corresponding to this expected image

8. The device according to claim 7, **characterized in that** the device comprises a duplexer (25) for emitting a characteristic signal from a network node, and for receiving an echo reflected by the conductor network of this emitted signal as an available signal.

9. The device according to claim 8, **characterized in that** the device comprises a circuit (74) in the available signal for eliminating leakage of the emitted signal.

10. The device according to one of claims 7 to 9, **characterized in that** the device comprises a reactive cap for identification fitted in parallel on the supply input of an apparatus.
